# EUROPEAN PATENT APPLICATION

(11) **EP 2 894 785 A1**
(43) Date of publication of application: **15.07.2015**
(21) Application number: 14305028.4
(22) Date of filing: 09.01.2014
(51) Int. Cl.: H03K 17/955

(54) **Contactless switch**

(71) Applicant: Open APP, 06700 Saint Laurent du Var (FR)
(72) Inventor: Airoldi, Roberto, 06700 Saint Laurent du Var (FR)
(74) Representative: de Zeeuw, Johan Diederick

(57) **Abstract**

Electrical switch for operating at least one electrical device, comprising a first module for generating instructions and a second module for switching on or off the connection between said at least one electrical device and a power source, wherein the first module comprises a capacitive sensor with a sensor electrode for detecting the intrusion of an object into the space near the sensor electrode and a first control unit connected to the sensor electrode for evaluating the change in the capacitance of the sensor electrode due to said intrusion and for generating an instruction based on said evaluation, and wherein the second module is provided with a switch member for closing or opening an electrical connection between said at least one electrical device and a power source, the switch member being operated by means of a second control unit, wherein the electrical switch is provided with communication means for connecting the first and second control units in order to operate the switch member by means of instructions generated by the first module.

## Description

### Field of the Invention

The present invention relates to an electrical switch for operating at least one electrical device, comprising a first module for generating instructions and a second module for switching on or off the connection between said at least one electrical device and a power source.

In the prior art, there exists a large variety of switches for operating electrical devices. Known switches have, for instance, the form of a button or a pivot which requires to be touched by the hand of a user. The switches are connected to the electrical device which is operated by the switch by means of wiring. Once such a switch has been positioned, for example inside a wall, the switch cannot be removed and replaced without incurring relatively high costs.

The switches which are known in the prior art have been used for many years and exist in a variety of forms and have been produced in a variety of different materials. The specific form of a switch depends normally on the use and the design requested by the user. An important influence on the specific form of the switch is the specific intended use of the switch and the budget available for producing the switch.

One of the problems with the switches according the prior art as described above is the fact that the switches need to be touched by the hands of the users. As a result, during use the switches become dirty and need to be cleaned regularly. For the same reason, switches can be a source of transmittal of bacteria between users. As such, the switches according to the prior art are not adapted for use in areas where hygiene is of the utmost importance, such as hospitals and clinics.

Given that the use of the switches according to the prior art requires that the switches be touched by the users also, the switches may be subject to wear and deterioration and, as a result, their visual appearance may necessitate the replacement of the switch even though the technical elements for switching the electrical device on or off may still be operable.

It should be noted that in many areas of technology, ergonomics have recently been substantially enhanced by improving the input devices which are used to generate instructions for the electronic object. A first example of such an improvement is the use of computers wherein instructions can be generated by devices such as mice or wherein the computer may comprise a touch screen which allows user-friendly generation of instructions for the use of the computer. Moreover, in many electrical devices adapted for daily use, wireless communication is used in order to generate an instruction at one location and to receive the instruction at a second, distant location. One example of this type of use is the remote control of a television wherein the user can be at a certain distance from the television screen while still being able to provide instructions for, for instance, increasing the volume or changing the channel.

Despite the availability of improvements in the ergonomics of the handling of electronic devices, switches used in homes and offices, for example light switches, have undergone relatively limited development over the years.

In view of the disadvantages of existing switches as described in the introduction, an object of the invention is to provide a switch which does not produce at least some of the disadvantages related to existing switches.

### Brief Description of the Invention

The invention relates to an electrical switch for operating at least one electrical device, comprising a first module for generating instructions and a second module for switching on or off the connection between said at least one electrical device and a power source, wherein the first module comprises a capacitive sensor with a sensor electrode for detecting the intrusion of an object into the space near the sensor electrode and a first control unit connected to the sensor electrode for evaluating the change in the capacitance of the sensor electrode due to said intrusion and generating an instruction based on said evaluation, and wherein the second module is provided with a switch member for closing or opening an electrical connection between said at least one electrical device and a power source, the switch member being operated by means of a second control unit, wherein the electrical switch is provided with communication means for connecting the first and second control units in order to operate the switch member by means of instructions generated by the first module.

According to the present invention, the electrical switch for operating at least one electrical device comprises a first and second separated module which communicate one with the other by means of communication means. The first module is adapted to generate instructions based on the movement of an object, such as the hand of a user. The second module is adapted to switch on or switch off the electrical device for which the electrical switch is used.

A first advantage of the present invention is that the electrical switch according to the invention provides more flexibility for the positioning of the first module and the second module. The first module can be positioned at any convenient position in order to allow ergonomic use of the electrical switch according to the invention. The second module will normally be positioned in the vicinity of the electrical device for which the electrical switch is used. The communication between the first module and the second module can take place in any adapted manner.

According to a first embodiment, communication between the first and the second module is obtained by means of a wire.

According to an alternative of the present invention, communication between the first and the second module is wireless. Wireless communication between the first and the second module can comprise any adapted means which are readily available for one of skill in the art. This means that communication can be obtained by means of a radio signal, a UV signal or any other adapted signal.

According to the present invention, the communication means can comprise means for radio communication.

According to the present invention, a means for radio electric communication can comprise an emitter and a receiver.

According to an embodiment of the present invention, the electrical switch is adapted to be integrated into an electrical circuit with at least a further electrical switch.

According to an embodiment of the present invention, the first module is connected to a source of electrical energy in the form of a battery and/or a photovoltaic cell.

An advantage of this embodiment is that the first module can operate independently from the second module when it comes to providing electrical energy to the first and second module.

According to an embodiment of the present invention, the first module can be integrated in the electrical device which is operated by the electrical switch according to the invention.

### Brief Description of the Drawings

The invention and the advantages of the invention over the prior art will be better understood after the following description of an embodiment of the invention wherein reference is made to the following drawings:
Figure 1 shows a first embodiment of the electrical switch according to the present invention with a first and a second module; and
Figure 2 shows an electrical circuit having a plurality of first modules adapted to generate instructions for operating a number of electrical devices.

### Detailed Description of an Embodiment of the Invention

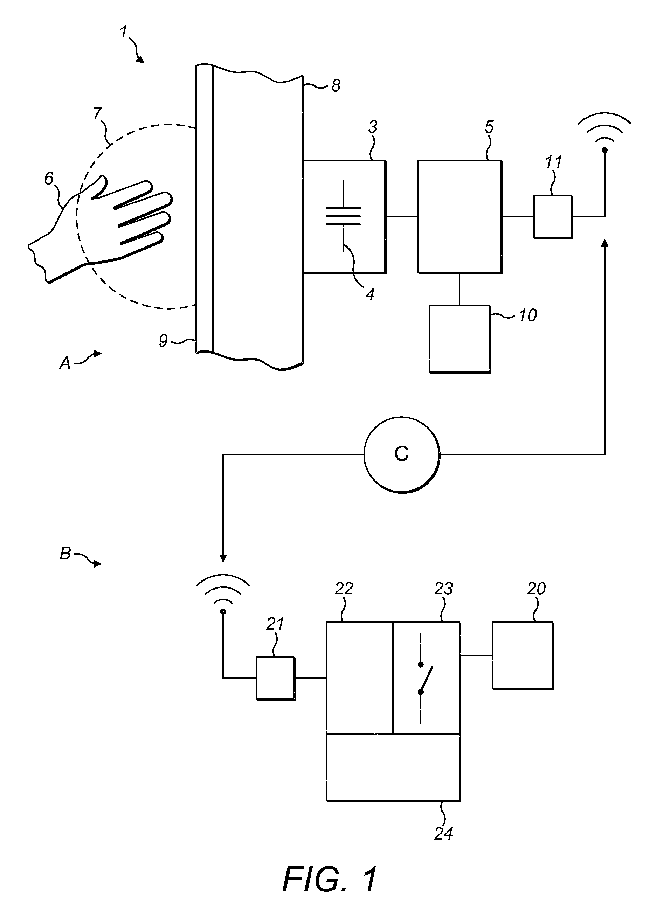

Figure 1 shows an embodiment of the electrical switch 1 according to the present invention. The electrical switch 1 comprises three main elements. The first element is the first module A which is adapted for generating instructions. The second element of the electrical switch is module B which is adapted to connect or disconnect an electrical device to or from a power source. The third element of electrical switch 1 according to Figure 1 is communication means C which allows modules A and B to communicate in order to allow electrical switch 1 to generate instructions by means of module A and to operate an electrical device by means of module B.

Module A comprises a capacitive sensor 3 having a sensor electrode 4 (which is schematically indicated in Figure 1). The sensor electrode 4 is used to be able to detect a change in the capacitance of the sensor electrode 4 in comparison to reference potential. The detection of a change in the capacitance of the sensor electrode 4 is achieved by means of a first control unit 5 which is connected to the capacitive sensor 3. According to a first embodiment, the first control unit 5 will couple the sensor electrode 4, at a given frequency, periodically and repeatedly with a given first potential. The control unit 5 will evaluate at least one parameter of a current and a voltage profile dependent on the periodic charging and discharging of the sensor electrode 4 in order to detect the capacitance change. The capacitance change of the sensor electrode 4 is due to the intrusion of an object 6 into the space 7 in front of the sensor electrode 4.

In the embodiment according to Figure 1, the capacitive sensor 3 is positioned behind a wall element indicated with reference number 8. The wall element 8 is decorated by means of a decoration layer 9 which could take the form of wallpaper or paint. The capacitive sensor 3 will generate an electrical field which is not hindered by the presence of either the wall element 8 or the decorative layer 9. As such, the electrical field generated by the capacitive sensor 3 will be present in front of the decorated wall element 8, 9 and will be accessible for any object. According to Figure 1, the object that is entered into the space 7 in front of the decorated wall 8, 9 is the hand of a user. Any other object could be introduced into the space 7 in order to generate a change of the capacitance of the sensor electrode 4.

From Figure 1, it will be understood that the generation of a change in the capacitance of the sensor electrode 4 can be obtained by introducing an object 6 into the space 7 without the need to make physical contact with an actual switch element. Moreover, it is not necessary to contact the decorative wall element 8, 9. The change in the capacitance of the sensor electrode 4 can be made without the need to make any contact between the object 6 and the capacitive sensor 3. The first control unit 5 is adapted to detect the change in capacitance and to translate the change in capacitance of the sensor electrode 4 into instructions. The first control unit 1 will be able to detect the introduction of an object 6 into the space 7 in front of the decorated wall 8, 9 and translate the intrusion of the object 6 in the space 7 into a signal for, for instance, switching on a light.

It is clear that any other function could be triggered by the intrusion of an object 6 in the space 7. Other examples are the opening of a door, the calling of an elevator, the ringing of a bell, or any other suited application. In order to make the various elements of the first module A work, the module A can be provided with a power source 10, which is specifically adapted to provide electrical energy for the various elements as presented above. In order to be able to use the instructions generated by the first control unit 5, the first module A is provided with communication means for communicating with the second module B. According to Figure 1, the first module A comprises an emitter 11. The emitter is capable of sending the instruction generated by the first control unit 5 towards a receiver which is part of module B. The communication means for allowing communication between the first module A and the second module B could have any other adapted form, such as the use of a simple wire. In the case of the use of a wire, the emitter 11 of the first module A and the receiver of the second module B would not be needed.

The bottom part of Figure 1 shows the second module B which is connected to the electrical device 20. Module B comprises a first element allowing communication of the second module B with the first module A. According to Figure 1, this element is a receiver 21. The receiver 21 is adapted to receive an instruction generated by the first control unit 5 and sent towards the second module B by means of the emitter 11. The receiver 21 will be coupled to a second control unit 22. The second control unit 22 is able to receive the instruction generated by the first control unit 5 and to translate this instruction into an action which comprises the operation of a switch member 23. When the first control unit 5 has generated an instruction, for instance, to switch off electrical device 20, the second control unit 22 will, after having received this instruction, open the electrical switch member 23. If the first control unit 5 has generated an instruction to switch on the electrical device 20, the second control unit 22 will operate the switch member 23 to allow electrical contact between electrical device 20 and the power source. As shown in Figure 1, the second module B is connected to an electrical power source 24. This power source could, for example, be the mains.

In an embodiment of the invention, the communication means C may comprise an emitter/receiver 11 which is part of module A and a receiver/emitter 21 which is part of module B. In the event both modules A and B comprise an emitter/receiver for communication with the other module, information can be sent from the one to the other and vice versa.

As indicated above, the fact that the capacitive sensor 3 is positioned behind a decorated wall 8, 9 does not create any problems for the functioning of the capacitive sensor 3. The decorated wall 8, 9 can comprise any material and may have a thickness of several centimetres.

In practice, the only disadvantage of having the sensor electrode "hidden" behind a wall means that the user may not readily recognise the position of the capacitive sensor 3 behind a wall. Therefore, on the visible part of the wall, on the part forming the decoration 9 of the wall 8, a marking may be present in order to indicate the presence of the capacitive sensor 3. This marking can have any form or shape and may be in line with the overall decoration of the room or area wherein the capacitive sensor 3 is used.

Should the connection between modules A and B be obtained by using a wire (not shown), the electrical switch 1 may comprise an electromagnetic or static relays. In the case where wiring is used for establishing communication between modules A and B, module A will replace a traditional switch, such as a light switch.

From the description of the invention above, the several advantages of the invention over the prior art are readily apparent. The generation of instructions in module A does not require any physical contact between an object, such as the hand 6 of a user, and any part of module A. Accordingly, the electrical switch 1 according to the invention is particularly suitable for areas where contact-free switches are preferable, for example hospitals, research laboratories, and other places where transmission of viruses and dirt should be avoided.

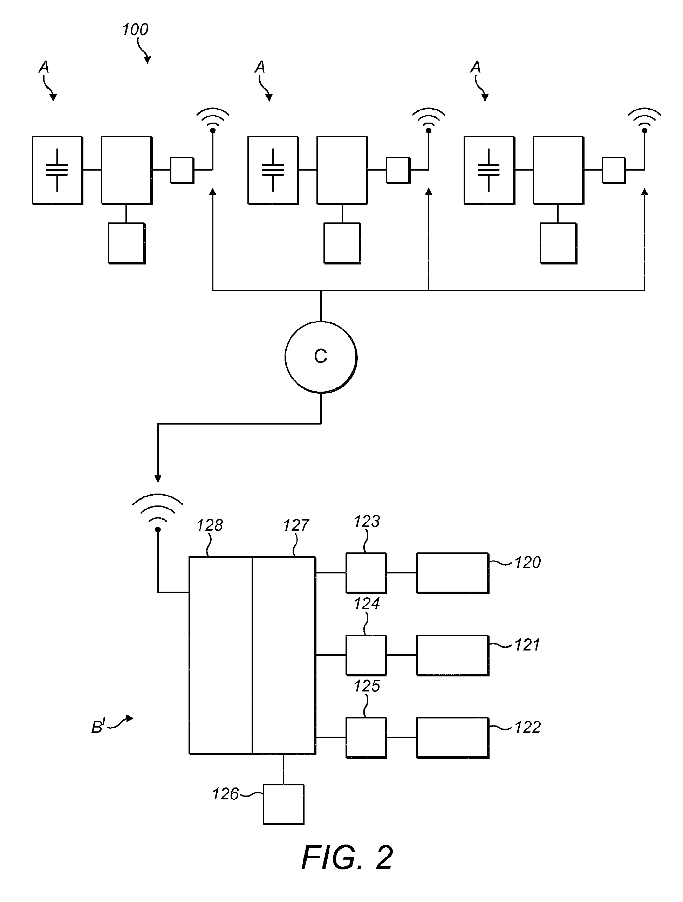

The fact that the module A does not require any contact means that no part of module A is exposed to any wear or deterioration during use. Another advantage of the electrical switch as shown in Figure 1 is the flexibility that is obtained by using the modules A and B. Module B only needs to be in the vicinity of the electrical device 20 for which the electrical switch 1 is used. The user has complete freedom to position module A in any convenient place. Moreover, several modules A could be used for operating a single electrical device 20. As will be described with reference to Figure 2, a series of modules A can be used in combination with a series of modules B or a module B which is capable of operating more than one electrical device.

In an embodiment of the invention, it is possible that the first control unit 5 is capable of detecting various instructions generated by the presence of an object, such as the hand 6 in the area 7 in front of the capacitive sensor 3. One criterion could be the time that the object is present in the space 7. A given number of seconds could generate the instruction to switch on or off a light. Shorter intervals could mean that the user would like to increase or decrease the intensity of the light once switched on. In the case where the electrical switch 1 is used for operating, for instance, a door, the amount of time the object is present in front of the capacitive sensor 3 might indicate the duration that the door should remain open before closing. Other alternatives will be readily available for the skilled person.

In the case where the module A is connected with the module B via a wireless contact, for instance using an emitter and a receiver 11, 21, the module A can operate independently and can be provided with an independent energy source 10. This energy source can be in the form of either a battery or, for example, a photovoltaic cell. The energy consumption of the module A is very low. As such, even if the battery or photovoltaic cell 10 has a low capacity to store electrical energy, the module A can operate for a relatively long period. It is even possible to envisage creating the module A as a disposable, taking into account the low energy consumption and relatively long lifetime of batteries which could be used in the module A.

It should be noted that the module A could be positioned at any convenient location. It would be possible to integrate module A in the exterior of the electrical device 20 for which the electrical switch 1 according to the invention is used.

In Figure 2, a second embodiment 100 of an electrical switch according to the invention is shown. The embodiment according to Figure 2 comprises a plurality of first modules A which cooperates with a second module B'. The plurality of modules A (three modules have been shown in Figure 2) communicates with the second module B' by means of communications means C. Figure 2 shows a wireless communication between the several modules A and B'. The modules A as shown in Figure 2 could be similar to the module A as shown in Figure 1. Module B' according to Figure 2 comprises a first 120, a second 121 and a third 122 electrical device which are operated by means of a first 123, a second 124 and a third 125 switch member. The switch members 123, 124 and 125 are adapted to connect or disconnect the electrical devices 120, 121 and 122 to or from a power source 126. The switch members 123, 124 and 125 are operated by means of a second control unit 127 which receives instructions from the receiver 128 of second module B'. In the configuration according to Figure 2, each module A could be adapted to provide instructions for any of the electrical devices 120, 121 or 122. Alternatively, a specific movement of an object in front of each of the modules A could provide specific instructions in order to switch on or off one of the devices 120, 121 or 122. For instance, an object which enters the vicinity of the capacitive sensor of any of the modules A for less than five seconds will generate instructions for the electrical device 120; an object which enters the vicinity of the capacitive sensor of any of the modules A for between five and ten seconds will provide instructions for the electrical device 121; and an object which enters the vicinity of the capacitive sensor of any of the modules A for longer than ten seconds will provide instructions for the third electrical device 122. Figure 2 shows that the electrical switch 1, 100 according to the present invention provides a limitless flexibility for using a module A for generating specific instructions for operating a specific electrical device 20, 120, 121 and 122.

Where the communication means C in a configuration according to Figure 1 or Figure 2 provides for wireless communication, the second module B, B' could be connected to an electronic device such as a computer that would allow, for instance, to add intelligence to the sending of instructions to second module B, B' and to connect the second module B, B', for example, to a specific time schedule.

Any instructions provided by any of the modules A could be visualised in real time on a screen at any specific location. Visualisation of these signals could be linked to the generation of an audible signal such as an alarm. It would also be possible to connect the generation of instructions by modules A to a feedback system to allow monitoring of the instructions generated by the module A and sent over to the second module B, B'.

In addition to the systems shown in Figures 1 and 2, it would be possible to use a plurality of first modules A to create specific man-machine systems. The best way to illustrate the use of several first modules A to generate specific instructions can be made by means of an example. Where the first modules A are used for generating an instruction to switch on or switch off a light, the combination of a first and a second first module A, one above the other, could be used, for instance to increase or decrease the intensity of the light once switched on. The first module A which is positioned above the other first module A could, for example, carry an indication in the form of an arrow pointing upwards. The second first module A positioned below the other first module A could be provided with an indication in the form of an arrow pointing downwards. A user moving his hand firstly over the upper first module A and then over the lower first module A could generate an instruction to lower the intensity of the light. When the action is reversed and the user moves his hand firstly over the lower first model A and then over the upper first module A, an instruction could be made to increase the light intensity. Further instructions could be provided, for instance, by adding a functionality such as keeping the hand above one of the two first modules A. If the hand of the user remains in front of the upper first module A for a number of seconds, the light intensity will go up until a maximum light intensity is reached. Similarly, if the hand of the user remains in front of the lower first module A, the light intensity will go down until a minimum light intensity is reached or until the light is switched off completely.

In addition to the embodiments described above, a first module A could comprise a first and a second sensor electrode. Each of the sensor electrodes could be coupled to the ground. In the case where a plurality of sensor electrodes is used, the presence of an object in a specific area near the sensor electrode could be detected by a difference in capacitance between the several electrodes used.

## Claims

1. Electrical switch for operating at least one electrical device, comprising a first module for generating instructions and a second module for switching on or off the connection between said at least one electrical device and a power source, wherein the first module comprises a capacitive sensor with a sensor electrode for detecting the intrusion of an object into the space near the sensor electrode and a first control unit connected to the sensor electrode for evaluating the change in the capacitance of the sensor electrode due to said intrusion and for generating an instruction based on said evaluation, and wherein the second module is provided with a switch member for closing or opening an electrical connection between said at least one electrical device and a power source, the switch member being operated by means of a second control unit, wherein the electrical switch is provided with communication means for connecting the first and second control units in order to operate the switch member by means of instructions generated by the first module.

2. Electrical switch according to claim 1, wherein the communication means comprise means for radio electric communication.

3. Electrical switch according to claim 2, wherein the means for radio electric communication comprise an emitter and a receiver.

4. Electrical switch according to claims 1, 2 or 3, wherein the electrical switch is adapted to be integrated into an electrical circuit with at least a further electrical switch.

5. Electrical switch according to one of the preceding claims, wherein the first module is connected to a source of electrical energy in the form of a battery and/or a photovoltaic cell.

6. Electrical switch according to one of the preceding claims, wherein the first module is integrated in the at least one electrical device.
